# EUROPÄISCHE PATENTSCHRIFT

(11) **EP 1 111 397 B1**
(45) Veröffentlichungstag und Bekanntmachung des Hinweises auf die Patenterteilung: **26.10.2005**
(21) Anmeldenummer: 00126789.7
(22) Anmeldetag: 06.12.2000
(51) Int. Cl.: G01R 31/28

(54) **Anordnung zum Testen von Chips mittels einer gedruckten Schaltungsplatte**
Means for testing chips using a printed circuit
Dispositif pour tester des pouces avec un circuit intégré

(30) Priorität: 21.12.1999 DE 19961791
(43) Veröffentlichungstag der Anmeldung: 27.06.2001
(73) Patentinhaber: Infineon Technologies AG, 81669 München (DE)
(72) Erfinder: Pöchmüller, Peter, 81379 München (DE)
(74) Vertreter: Müller - Hoffmann & Partner

(56) Entgegenhaltungen:
- WO-A-95/23340
- WO-A-97/30358
- WO-A-98/01906
- FR-A- 2 505 127
- US-A- 5 034 685

## Beschreibung

Die vorliegende Erfindung betrifft eine Anordnung zum Testen von Chips, d.h. von in diesen Chips realisierten integrierten Schaltungen, mittels einer gedruckten Schaltungsplatte (PCB = Printed Circuit Board), bei der durch Sonden-Nadeln, bevorzugt auch Probe-Nadeln genannt, eine elektrische Verbindung zwischen der PCB und dem Chip hergestellt wird.

Das Testen von Chips wird bevorzugt auf Waferebene vorgenommen, da dort eine Vielzahl von Chips parallel bearbeitet werden kann, was eine erhebliche Zeit- und Kostenersparnis mit sich bringt. In letzter Zeit werden besonders hochparallele Kontaktierungsmethoden, die auf Nadeln mit kleinen Abmessungen basieren und beispielsweise einen Formfaktor berücksichtigen, als erfolgversprechend angesehen. Solche Tests können grundsätzlich mittels zwei verschiedenen Methoden durchgeführt werden:

Bei der ersten Methode ist eine Anzahl von sehr genauen Probe-Nadeln auf jedem Chip vorgesehen, und diese Probe-Nadeln werden in Kontakt mit Pads bzw. Kontaktkissen auf einer PCB gebracht.

Bei der zweiten Methode sind die Sonden-Nadeln in großer Anzahl auf einer Sonden- bzw. Probe-Karte angebracht, die zum parallelen Testen mehrerer Chips herangezogen wird.

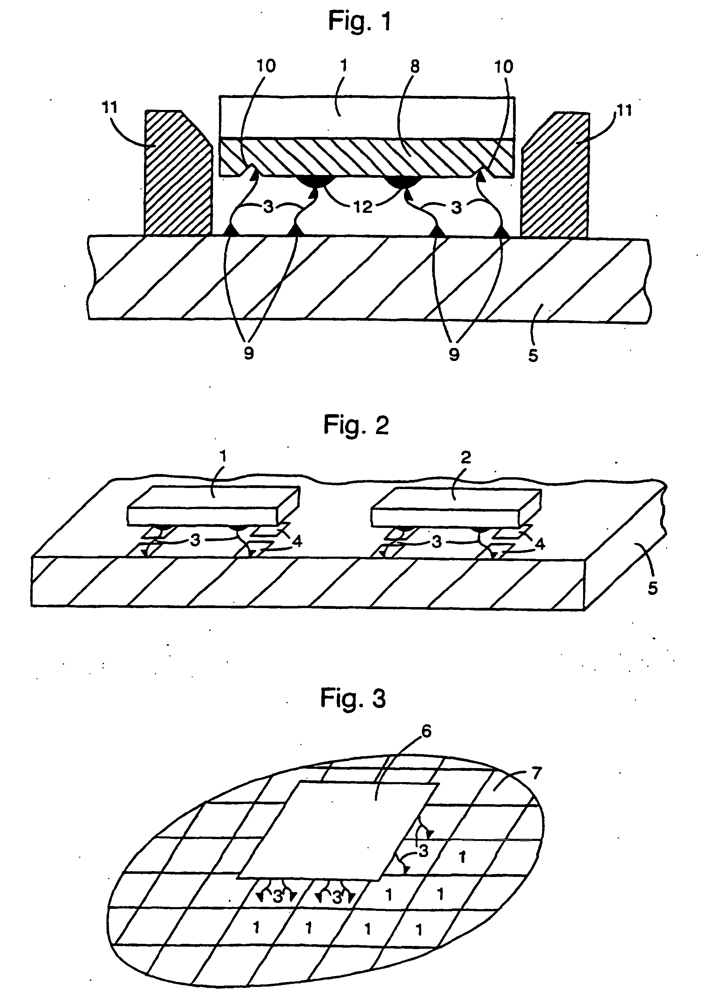

Die erste und die zweite Methode sind in der Fig. 2 bzw. der Fig. 3 veranschaulicht:

In Fig. 2 sind Chips 1, 2 jeweils mit Probe-Nadeln 3 versehen, die in Berührung mit Pads 4 auf einer PCB 5 gebracht werden.

Die zweite Methode verwendet dagegen eine Probe-Karte 6, die mit einer Vielzahl solcher Probe-Nadeln 3, ausgestattet ist, welche in Berührung mit einer Vielzahl von Chips 1 auf einem Halbleiter-Wafer 7 aus Silizium gebracht werden.

Die erste Methode erlaubt ein paralleles Testen der einzelnen Chips 1, 2 auf der PCB 5, wobei darauf geachtet werden muß, daß die Probe-Nadeln 3 jeweils ihre zugeordneten Pads 4 treffen und diese zuverlässig kontaktieren. Nachteilhaft hierbei ist, daß die Zentrierung der einzelnen Probe-Nadeln auf die Pads schwierig einzuhalten ist und daß weiterhin die Probe-Nadeln fest mit den einzelnen Chips verbunden werden müssen, was die weitere Verarbeitung erschwert: die Probe-Nadeln können nämlich praktisch nicht entfernt werden, so daß sie bei dem weiteren Einsatz der Chips berücksichtigt werden müssen. Außerdem stellt es einen beträchtlichen Kostenaufwand dar, für jeden Chip einen vollständigen Satz von Probe-Nadeln zu verwirklichen.

Die zweite Methode mit der Probe-Karte 6 weist den zuletzt genannten Nachteil eines hohen Aufwandes für Probe-Nadeln für jeden Chip nicht auf: hier kann die Probe-Karte mit ihren Probe-Nadeln nacheinander verschiedene Sätze von Chips bzw. deren Pads kontaktieren. Sie hat aber den Nachteil, daß ein Kontaktieren der Chips eines ganzen Halbleiter-Wafers praktisch ausgeschlossen ist, da nach derzeitigem Stand der Technik die Realisierung von Probe-Karten mit einigen 10.000 einzelner Probe-Nadeln nicht möglich ist. Dies wäre aber erforderlich, da ein Halbleiter-Wafer bis zu 1000 Chips aufweisen kann und für jeden von diesen einzelnen Chips etwa 60 Probe-Nadeln benötigt werden, so daß insgesamt die Probe-Karte zum Testen eines Wafers bzw. der in dem Wafer realisierten Chips 60.000 Probe-Nadeln notwendig wären. Es braucht auch nicht besonders betont zu werden, daß ein Arbeiten mit einer derart großen Anzahl von Probe-Nadeln eine extrem hohe Genauigkeit in lateraler und senkrechter Richtung, also in der Ebene des Halbleiter-Wafers und in der zu dieser Ebene senkrechten Richtung, erfordert.

Die WO 95/23340 beschreibt eine Testanordnung zum Testen einer gedruckten Schaltungsplatte mittels eines Testadapters. Dieser Testadapter besteht aus zwei Untereinheiten TF, TA sowie BF, BA, in denen ein erster und ein zweiter Satz Kontaktelemente S bzw. H und Justierelemente T geführt sind. Die Kontaktelemente H werden als "relativ massive Stifte" (vgl. Seite 5, Zeile 7) bezeichnet und sind dabei deutlich dünner als die Justierelemente T. Lediglich die Kontaktelemente S sind als dünne, eng angeordnete Stifte angegeben (vgl. Seite 5, Zeile 9).

Mit derartigen Stiften ist zwar ohne weiteres eine gedruckte Schaltungsplatte justierbar und gegebenenfalls auch kontaktierbar. Dies gilt jedoch nicht für einen mit integrierten Schaltungen versehenen Chip, der infolge der eng beieinanderliegenden Kontaktstellen den Einsatz von elastischen Nadeln erfordert, um eine Zerstörung dieser Kontaktstellen zu vermeiden.

Die in der WO 95/23340 beschriebene Testanordnung ist daher zum Testen eines Chips nicht geeignet.

In der WO 98/01906 wird ein Halbleiterchip beschrieben, der anstatt mit herkömmlichen Lötkugeln (solder balls) mittels auf den Pads angebrachter Federelemente (springs) auf ein Substrat montiert wird. Da diese mechanisch hochempfindlichen Federelemente im Herstellungsprozess vor Verbiegung geschützt werden müssen, wird ein Schutzelement (floating lateral support) eingeführt, der sowohl eine Schutz- als auch eine Führungsfunktion für die Federelemente gewährleistet.

Es wird jedoch nicht auf die in der vorliegenden Anmeldung relevante Aufgabenstellung des Testens von Halbleiterchips eingegangen. Darüber hinaus erhält der Fachmann auch keinen Hinweis auf eine Lösung, wonach Federelemente unmittelbar auf dem Chip - und nicht auf einem Substrat - aufgebracht werden können. Weiterhin offenbart die WO 98/01906 keine Anregung zur Nutzung von Dummy-Nadeln, welche eine mechanische Selbstjustierung des Chips in einer wie auch immer gestalteten Aufnahmevorrichtung bewirken könnten.

Ausgehend von dem oben aufgezeigten Stand der Technik ist es Aufgabe der vorliegenden Erfindung, eine Anordnung zum Testen von Chips zu schaffen, die ein paralleles Testen einer großen Anzahl von Chips mit Selbstjustierung erlaubt.

Diese Aufgabe wird bei einer Anordnung der eingangs genannten Art erfindungsgemäß dadurch gelöst, daß die Probe-Nadeln direkt auf der applikationsnah gestalteten PCB so angebracht sind, daß auf der PCB mehrere Chips parallel zu testen sind.

Mit diesem Konzept weicht die Erfindung grundsätzlich von dem bisherigen Stand der Technik ab: die Probe-Nadeln sind nicht mehr auf dem Chip, wie bei der obigen ersten Methode, und ebenfalls nicht mehr auf der Probe-Karte, wie bei der obigen zweiten Methode vorgesehen. Vielmehr sind die Probe-Nadeln auf der PCB direkt angebracht, so daß bei der Erfindung weder eine Probe-Karte mit einer möglichst großen Anzahl von Probe-Nadeln noch Probe-Nadeln auf den einzelnen Halbleiterchips benötigt werden. Die PCB selbst sollte dabei möglichst applikationsnah realisiert werden und beispielsweise den späteren Einsatz von Speicherchips auf einem DIMM-Modul (DIMM = Dual-Inline Memory Module) nachbilden.

Das direkte Anbringen der Probe-Nadeln auf der PCB ermöglicht das parallele Kontaktieren und Testen einer großen Anzahl von einzelnen Chips. Für das Testen von Speicherchips wird in vorteilhafter Weise eine DIMM-ähnliche PCB verwendet, da eine solche PCB das Testen des Speicherchips unter Anwendungsbedingungen erlaubt.

Besonders vorteilhaft ist es, wenn auf der PCB zusätzlich Dummy-Nadeln zur mechanischen Selbstjustierung der Chips angebracht sind. Diese Dummy-Nadeln können dann mit ihren von der PCB abgewandten freien Enden in Zentrierungsstrukturen eingreifen, bei denen es sich um Vertiefungen handeln kann, die auf einem mit dem Chip verbundenen Zwischenstück bzw. "Interposer" vorgesehen sind. Ein solcher Interposer kann aus Kunststoff oder Kunststoff und Metall bestehen und ist fest mit dem eigentlichen Chip verbunden.

Ein wesentlicher Vorteil der Erfindung ist darin zu sehen, daß im Gegensatz zu dem Stand der Technik gemäß der obigen ersten Methode die Probe-Nadeln nicht mehr mit den einzelnen Chips verbunden sind. Dadurch ist insgesamt eine wesentlich geringere Menge an Nadeln erforderlich, da die auf der PCB angebrachten Nadeln für das Testen folgender Chips ohne weiteres eingesetzt werden können. Im Gegensatz zu der obigen zweiten üblichen Methode müssen bei der erfindungsgemäßen Anordnung keine so hohen Forderungen an die Genauigkeit wie bei Probe-Karten gestellt werden: Durch die Dummy-Nadeln kann nämlich eine Selbstzentrierung erreicht werden, bei der durch diese Dummy-Nadeln eine korrekte Justierung der Probe-Nadeln auf den Pads des Chips bzw. Interposers gewährleistet wird.

Auch erlaubt die erfindungsgemäße Anordnung ein Testen unter ähnlichen Bedingungen wie bei einer tatsächlichen Anwendung der Chips. Dadurch ist es möglich, auf Sicherheitsspannen bei Tests zu verzichten, da fehlerhafte Chips zuverlässig ausgesiebt werden können.

Schließlich besteht ein weiterer Vorteil der erfindungsgemäßen Anordnung darin, daß im Gegensatz zu der obigen herkömmlichen ersten Methode auf aufwendige und genaue Anbringung von Fassungen bzw. Sockets auf der PCB verzichtet werden kann, welche oft anstelle von Pads notwendig sind.

Nachfolgend wird die Erfindung anhand der Zeichnungen näher erläutert. Es zeigen:
- Fig. 1: eine erfindungsgemäße Anordnung in einer schematischen Schnittdarstellung,
- Fig. 2: eine herkömmliche Anordnung, die die erste Methode verwendet, bei welcher Probe-Nadeln an einzelnen Chips angebracht sind, und
- Fig. 3: eine andere herkömmliche Anordnung, bei welcher Probe-Nadeln an einer Probe-Karte angebracht sind.

Die Fig. 2 und 3 sind bereits eingangs erläutert worden. In den Figuren werden einander entsprechende Bauteile jeweils mit den gleichen Bezugszeichen versehen.

In Fig. 1 ist ein Chip mit einem Interposer 8 versehen, der in üblicher Weise aus Kunststoff besteht, in welchem Metallbahnen verlaufen. Dieser Interposer 2 kann aber gegebenenfalls auch weggelassen werden. Die Zentrierung erfolgt dann so, daß in den obersten Chipschichten aus beispielsweise Polyimid und/oder Siliziumdioxid entsprechende Zentrierungsstrukturen eingeätzt werden.

Weiterhin zeigt Fig. 1 eine PCB- 5, die beispielsweise aus Epoxydharz besteht und auf der in üblicher Weise Leiterbahnen verlaufen. Auf diesen (nicht gezeigten) Leiterbahnen bzw. auf der Oberfläche der PCB 5 sind an Befestigungsstellen 9 Probe-Nadeln 3 angebracht. Dabei wirken die in Fig. 1 beiden ganz äußeren Probe-Nadeln, die in Vertiefungen 10 des Interposers 8 eingreifen, als Dummy-Nadeln, die nicht elektrisch angeschlossen, also beispielsweise direkt auf der Oberfläche der PCB angebracht sind.

Justierhilfen 11, die fest mit der PCB 5 verbunden sind, erlauben ein Einführen des Chips 1 mit dem Interposer 8, so daß die Dummy-Nadeln 3 (in Fig. 1 ganz außen) in die Vertiefungen 10 gleiten und den Chip 1 mit dem Interposer 8 genau über den Probe-Nadeln 3 (in Fig. 1 innen) justieren, wodurch diese Probe-Nadeln 3 entsprechende Kontaktpads 12 auf dem Interposer 8 kontaktieren. Von diesen Kontaktpads 12 führen entsprechende Leiterbahnen durch den Interposer 8 zu dem Chip 1, so daß dieser in seinen Funktionen getestet werden kann, sobald die Probe-Nadeln 3 die Kontaktpads 12 berühren und damit eine elektrische Verbindung zu einem nicht gezeigten Tester herstellen.

Anstelle der Vertiefungen 10 können gegebenenfalls auch andere Markierungen vorgesehen werden, wie beispielsweise in den oberen Chiplagen aus Polyimid.und/oder Siliziumdioxid eingeätzte Strukturen. Eine derartige Gestaltung kann vorteilhaft sein, wenn auf den Interposer 8 verzichtet wird und die Kontaktgabe von den Probe-Nadeln 3 direkt zur Unterseite des Chips 1 erfolgt.

Auf der PCB 5 können Anordnungen, wie diese in Fig. 1 gezeigt sind, in großer Anzahl nebeneinander vorgesehen werden, so daß es möglich ist, eine Vielzahl von Chips gleichzeitig parallel auf dieser PCB zu testen. Für dieses parallele Testen kann ein Tester ausreichend sein, wenn dieser die Ergebnisse der parallel zueinander liegenden Chips in entsprechender Weise auszuwerten vermag.

## Patentansprüche

1. Anordnung zum Testen von Chips (1) mittels einer gedruckten Schaltungsplatte, PCB, (5), bei der eine elektrische Verbindung zwischen der PCB (5) und dem Chip (1) herstellbar ist und auf der PCB (5) mehrere Chips parallel zu testen sind,
**dadurch gekennzeichnet, daß** die elektrische Verbindung durch direkt auf der PCB (5) angebrachte Probe-Nadeln (3) herstellbar ist und daß auf der PCB (5) zusätzlich als Dummy-Nadeln (3) wirkende Probe-Nadeln zur mechanischen Selbstjustierung der Chips (1) angebracht sind.

2. Anordnung nach Anspruch 1,
**dadurch gekennzeichnet, daß** die Dummy-Nadeln (3) mit ihrem von der PCB (5) abgewandten freien Enden in Markierungen eingreifen.

3. Anordnung nach Anspruch 2,
**dadurch gekennzeichnet, daß** die Markierungen Vertiefungen (10) sind.

4. Anordnung nach einem der Ansprüche 1 bis 3,
**dadurch gekennzeichnet, dass**
zwischen den Nadeln (3) und dem Chip (1) ein Zwischenstück (8) vorgesehen ist oder dass Zentrierungsstrukturen direkt in die Oberfläche des Chips (1) eingebracht sind.

5. Anordnung nach einem der Ansprüche 1 bis 4,
**dadurch gekennzeichnet, dass**
die PCB (5) mit Justierhilfen (11) versehen, ist, zwischen denen die Chips (1) einführbar sind.

## Claims

1. Arrangement for testing chips (1) using a printed circuit board, PCB, (5), in which an electrical connection can be produced between the PCB (5) and the chip (1) and a plurality of chips can be tested in parallel on the PCB (5),
**characterized in that**
the electrical connection can be produced by probe needles (3) fitted directly on the PCB (5), and **in that** probe needles acting as dummy needles (3) are additionally fitted on the PCB (5) for the purpose of mechanical self-alignment of the chips (1).

2. Arrangement according to Claim 1,
**characterized in that**
the dummy needles (3) engage in markings with their free ends remote from the PCB (5).

3. Arrangement according to Claim 2,
**characterized in that**
the markings are depressions (10).

4. Arrangement according to one of Claims 1 to 3,
**characterized in that**
an adapter (6) is provided between the needles (3) and the chip (1) or **in that** centring structures are introduced directly into the surface of the chip (1).

5. Arrangement according to one of Claims 1 to 4,
**characterized in that**
the PCB (5) is provided with alignment aids (11), between which the chips (1) can be inserted.

## Revendications

1. Dispositif pour tester des puces (1) au moyen d'une plaquette à circuit imprimé, PCB, (5), dans lequel une liaison électrique entre la PCB (5) et la puce (1) peut être produite et plusieurs puces sont testées en parallèle sur la PCB (5),
**caractérisé en ce que** la liaison électrique peut être ménagée par des aiguilles (3) sondes montées directement sur la PCB (5) et **en ce qu'**il est monté, en outre, sur la PCB (5) des aiguilles sondes servant de fausses aiguilles (3) pour l'auto-alignement mécanique des puces (1).

2. Dispositif suivant la revendication 1,
**caractérisé en ce que** les fausses aiguilles (3) pénètrent par leur extrémité libre, éloignée de la PCB (5), dans des repères.

3. Dispositif suivant la revendication 2,
**caractérisé en ce que** les repères sont des cavités.

4. Dispositif suivant l'une des revendications 1 à 3,
**caractérisé en ce qu'**il est prévu entre les aiguilles (3) et la puce (1) une pièce (8) intermédiaire ou **en ce que** des structures de centrage sont insérées directement dans la surface de la puce (1).

5. Dispositif suivant l'une des revendications 1 à 4,
**caractérisé en ce que** la PCB (5) est muni d'aides (11) à l'alignement entre lesquelles les puces (1) peuvent être introduites.
